Europäisches Patentamt

European Patent Office

Office européen des brevets

(11) Veröffentlichungsnummer: **0 195 117**
A2

(12) # EUROPÄISCHE PATENTANMELDUNG

(21) Anmeldenummer: **85113217.5**

(22) Anmeldetag: **18.10.85**

(51) Int. Cl.⁴: **H 01 H 1/02**
**H 01 H 11/04**

(30) Priorität: **14.03.85 DE 3509039**

(43) Veröffentlichungstag der Anmeldung:
**24.09.86 Patentblatt 86/39**

(84) Benannte Vertragsstaaten:
**CH DE FR GB LI**

(71) Anmelder: **W.C. Heraeus GmbH**
**Heraeusstrasse 12 - 14**
**D-6450 Hanau / Main(DE)**

(72) Erfinder: **Witting, Karin**
**Lortzingstrasse 7**
**D-6457 Maintal 4(DE)**

(72) Erfinder: **Pöss, Dieter, Dr.**
**Kath. Belgica-Strasse 7b**
**D-6450 Hanau 1(DE)**

(72) Erfinder: **Schnabl, Rudolf**
**Würzburger Strasse 21**
**D-6458 Rodenbach 1(DE)**

(74) Vertreter: **Heinen, Gerhard, Dr.**
**W.C. Heraeus GmbH Zentralbereich Patente und**
**Lizenzen Heraeusstrasse 12-14**
**D-6450 Hanau(DE)**

(54) **Verbundwerkstoff für elektrische Kontakte und Verfahren zu seiner Herstellung.**

(57) Es wird ein Verbundwerkstoff für elektrische Kontakte beschrieben, der auf einer Unterlage aus Unedelmetall oder einer Unedelmetall- Legierung eine Kontaktschicht aus Titan-Nitrid ausweist, die ihrerseits mit einer Mischschicht aus Titan-Nitrid und wenigstens einem Edelmetall bedeckt ist. Ferner wird die Herstellung eines Verbundwerkstoffs in einem einzigen Arbeitsgang in einer Vakuumanlage unter reaktiver Bildung des Titan-Nitrid offenbart.

EP 0 195 117 A2

Hanau/Main, 6. März 1985
ZPL-Dr.Hn/St

W. C. Heraeus GmbH, Hanau

Patent- und Gebrauchsmusterhilfsanmeldung

"Verbundwerkstoff für elektrische Kontakte
und Verfahren zu seiner Herstellung"

<u>Patentansprüche</u>

1. Verbundwerkstoff für elektrische Kontakte, vorzugsweise
   für Schalt-, Steck- oder Schleifkontakte, der auf einer
   Unterlage, wie einer Kontaktfeder oder einem Kontaktstift,
   aus einem Unedelmetall oder einer Unedelmetall-Legierung
   eine Kontaktschicht aus Titan-Nitrid aufweist, dadurch
   gekennzeichnet, daß die der Unterlage (1) abgekehrte Oberfläche der Titan-Nitrid-Schicht (2) eine Mischschicht
   (3) aus Titan-Nitrid und wenigstens einem Edelmetall aus
   der Gruppe Gold, Silber, Palladium, Platin, Ruthenium,
   Rhodium und Iridium aufweist, deren Dicke etwa 1/10 bis
   3/10 der Schichtdicke der Titan-Nitrid-Schicht (2) beträgt
   und deren Edelmetallgehalt zwischen 40 und 95 % beträgt.

2. Verbundwerkstoff nach Anspruch 1, dadurch gekennzeichnet,
   daß in der Mischschicht ( 3) deren Bestandteile gleichmäßig
   verteilt vorliegen.

3. Verbundwerkstoff nach Anspruch 1, dadurch gekennzeichnet,
   daß in der Mischschicht (3) ein Konzentrationsgefälle
   des Edelmetalls vorliegt, wobei dessen Konzentration von
   der kontaktgebenden Oberfläche der Mischschicht nach innen
   zu abnimmt.

4. Verbundwerkstoff nach einem der Ansprüche 1 bis 3, dadurch gekennzeichnet, daß die Schichtdicke der Titan-Nitrid-Schicht 0,5 bis 1,5 μm und die Dicke der Mischschicht 0,05 bis 0,45 μm beträgt.

5. Verbundwerkstoff nach einem oder mehreren der vorhergehenden Ansprüche, dadurch gekennzeichnet, daß die Unterlage (1) aus Kupfer, einer Kupfer-Legierung, einer Nickel-Legierung, Stahl, Molybdän oder Wolfram besteht.

6. Verfahren zur Herstellung eines Verbundwerkstoffes für elektrische Kontakte nach einem oder mehreren der Ansprüche 1 bis 5, bei dem auf eine Unterlage in einem, gegebenenfalls Argon enthaltenden Behälter, in dem ein Druck von weniger als 5 x 10$^{-2}$ mbar aufrechterhalten wird, eine Kontaktschicht aus Titan-Nitrid- Schicht niedergeschlagen wird, dadurch gekennzeichnet, daß in den Behälter während des Beschichtungsverfahrens zur Reaktion mit verdampftem oder zerstäubtem Titan Stickstoff eingeleitet, das Reaktionsprodukt Titan-Nitrid auf der erwärmten Unterlage niedergeschlagen wird, und daß nach Erreichen einer vorgegebenen Kontaktschichtdicke zur Bildung einer Mischschicht ohne Unterbrechung der Titan-Nitrid-Bildung zusätzlich Edelmetall verdampft oder zerstäubt und dieses zusammen mit dem gebildeten Titan-Nitrid auf der Kontaktschicht niedergeschlagen wird.

7. Verfahren nach Anspruch 6, dadurch gekennzeichnet, daß die Unterlagen vor ihrer Beschichtung in dem Behälter in einer Heizstation auf eine Temperatur von wenigstens 250 $^{o}$C erwärmt werden.

8. Verfahren nach den Ansprüchen 6 und/oder 7, dadurch gekennzeichnet, daß zur Einstellung eines Konzentrationsgefälles in der Mischschicht Blenden verwendet werden, die jeweils zwischen der zu beschichtenden Unterlage und einer Titanquelle bzw. einer Edelmetallquelle angeordnet sind.

Kontaktschicht niedergeschlagen. Bewährt hat es sich, die zu beschichtende Unterlage vor ihrer Beschichtung in dem Behälter in einer Heizstation auf eine Temperatur von wenigstens 250 °C zu erwärmen. Die Einstellung eines Konzentrationsgefälles in der Mischschicht erfolgt beispielsweise unter Verwendung von Blenden, die jeweils zwischen der zubeschichtenden Unterlage und einer Titanquelle bzw. der Edelmetallquelle angeordnet sind.

Die erfindungsgemäßen Verbundwerkstoffe besitzen sowohl hohe mechanische Verschleißfestigkeit als auch hohe elektrische Leitfähigkeit, d. h. einen geringen Kontaktwiderstand. Sie sind also hinsichtlich ihrer mechanischen und elektrischen Eigenschaften gegenüber dem bekannten Verbundwerkstoff mit Titan-Nitrid- Kontaktschicht optimiert. Die Kontaktschicht aus Titan-Nitrid wirkt sich auf die in der Mischschicht ebenfalls enthaltenen Titan-Nitridteilchen als wirksame Stütze für die Mischschicht aus, durch deren Edelmetallgehalt eine außerordentliche Verminderung des Kontaktwiderstandes bewirkt wird. Die Tatsache, daß Titan-Nitrid sowohl in der Kontaktschicht als auch in der Mischschicht vorliegt, und beide Schichten ohne Unterbrechung des Beschichtungsprozesses erfindungsgemäß hergestellt werden, führt zu einer besonders guten, mechanischen Verbindung beider Schichten miteinander.

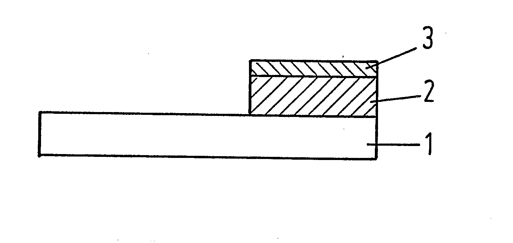

In der Figur ist schematisch ein erfindungsgemäß ausgebildeter Verbundwerkstoff dargestellt.

Mit der Bezugsziffer 1 ist die Unterlage aus Unedelmetall bezeichnet. Diese ist mit der Kontaktschicht 2 aus Titan-Nitrid beschichtet. Auf die der Unterlage 1 abgekehrte Oberfläche der Kontaktschicht 2 ist die Mischschicht aus Titan-Nitrid und wenigstens einem Edelmetall aus der im Anspruch 1 angegebenen Gruppe aufgebracht. Die Dicke der Kontaktschicht 2 liegt vorzugsweise im Bereich von 0,8 und 1,2 µm, die Dicke der Mischschicht zwischen 0,08 und 0,36 µm. Die Edelmetallkonzentration in der Mischschicht liegt vorzugsweise zwischen
70 und 90 % .

Die Herstellung eines erfindungsgemäßen Verbundwerkstoffs,
wie er in der Figur dargestellt ist, erfolgt vorteilhafterweise
durch reaktives Beschichten in einer evakuierten Anlage,
wobei das Titan und das Edelmetall beispielsweise durch Elektronenstrahlverdampfung oder durch Kathodenzerstäubung erzeugt
werden und wobei als Reaktionsgas während der Durchführung
der Beschichtung Stickstoff in einem auf Vakuum gehaltenen
Behälter eingeleitet wird. Im Falle der Kathodenzerstäubung
wird zusätzlich noch ein Trägergas, üblicherweise Argon,
während des Beschichtungsverfahrens in den evakuierten Behälter
eingeleitet. Zur Durchführung des Beschichtungsverfahrens
können handelsübliche Beschichtungsanlagen verwendet werden.

An Hand des nachfolgenden Beispiels wird die Beschichtung
der Unterlage 1 unter Verwendung einer üblichen Hochleistungszerstäubungsanlage beschrieben. Zunächst werden in einen
evakuierbaren Behälter mehrere Unterlagen 1 auf Substrathaltern
eingebracht. Dieser Behälter enthält sowohl eine Zerstäubungskathode aus Titan als auch eine Zerstäubungskathode aus Edelmetall, beispielsweise Gold, die mit Abstand zueinander angeordnet sind. Er enthält außerdem eine Aufheizstation, in der
die auf den Substrathaltern angeordneten Unterlagen zunächst
auf eine Temperatur von wenigstens 250 $^\circ$C, vorzugsweise auf
350 $^\circ$C vorgeheizt werden. Der Behälter wird zunächst auf
ein Hochvakuum von $1 \times 10^{-5}$ mbar evakuiert; danach werden
Stickstoff und Argon über separate Zuleitungen in den Behälter
eingelassen, so daß ein Stickstoffpartialdruck von etwa 3
$\times 10^{-4}$ bis $10 \times 10^{-4}$ mbar vorliegt, der während des Beschichtungsverfahrens aufrecht erhalten wird. Die Argonzufuhr erfolgt
in solchem Umfang, daß ein Gesamtdruck in dem Behälter von
weniger als $5 \times 10^{-2}$ mbar, beispielsweise zwischen $6 \times 10^{-3}$ und $2 \times 10^{-2}$ mbar während

der Beschichtung aufrechterhalten wird. Die Substrathalter
mit den vorerwärmten Unterlagen werden zwischen die beiden
Zerstäubungskathoden gebracht und zunächst wird Titan zerstäubt,
daß mit dem in dem Behälter befindlichen Stickstoff zu Titan-
Nitrid reagiert. Das Reaktionsprodukt Titan-Nitrid wird
auf den Unterlagen abgeschieden. Eine typische Substratstromdichte beträgt etwa 3 mA/cm$^2$ und die Sputterleistungen liegen
im Bereich von etwa 15 bis 20 W/cm$^2$. Nach Erreichen der gewünschten Kontaktschichtdicke wird zusätzlich, ohne Unterbrechung
der Titan-Nitrid-Bildung, von der Edelmetallkathode Gold
abgestäubt und dieses zusammen mit gebildetem Titan- Nitrid
zur Bildung der Mischschicht auf der Kontaktschicht niedergeschlagen, so daß sich eine gleichmäßige Verteilung der
Mischschichtbestandteile in der Mischschicht ergibt.

Nachfolgende Tabelle zeigt eine Gegenüberstellung erfindungsgemäß ausgebildeten Verbundwerkstoffes und eines Verbundwerkstoffes nach dem eingangs genannten Stand der Technik.
Untersucht wurden der Kontaktwiderstand, das Korrosionsverhalten
und die Reibfestigkeit der beiden Verbundwerkstoffe. Wie
sich durch den Vergleich der Meßgrößen, die einen Mittelwert
zahlreicher Einzelmessungen darstellen, ergibt, ist der erfindungsgemäße Verbundwerkstoff dem des Standes der Technik
erheblich überlegen. Die Meßwerte wurden unter Anwendung
von auf dem Gebiet der elektrischen Kontaktwerkstoffe üblichen,
an sich bekannten Testverfahren erhalten. Als erfindungsgemäßer
Verbundwerkstoff wurde ein solcher eingesetzt, bei dem das
Edelmetall in der Mischschicht aus Gold besteht, welches
gleichmäßig in Titan-Nitrid verteilt vorlag. Die Konzentration
des Goldes in der Mischschicht betrug 95 %. Als Werkstoff
für die Unterlage wurde in beiden Fällen Molybdän verwendet.
Die Dicke der Kontaktschicht betrug in beiden Fällen 1μm.
Die Dicke der Mischschicht betrug o,2 μm.

| | Kontaktwiderstand bei 2o cN | Korrosionstest * Kontaktwiderstand nach Auslagerung Kontaktkraft 20 cN | Reibkorrosions- verhalten, ** $R_k$ nach 1000 Reibzyklen |
|---|---|---|---|
| Mo mit TiN | 1 $\Omega$ | 10 $\Omega$ | 1 $\Omega$ |
| Mo mit TiN und Misch- schicht | 10 m$\Omega$ | 10 m$\Omega$ | 10 m$\Omega$ |

\* Korrosionsbedingungen: 1 ppm $H_2S$; 25 $^o$C; 75 % relat. Feuchte; Dauer 21 Tage.

\*\* Reibweg 50 µm; Reibkraft 50 cN; Frequenz 2 Hz.

W. C. Heraeus GmbH, Hanau

Patent- und Gebrauchsmusterhilfsanmeldung

"Verbundwerkstoff für elektrische Kontakte
und Verfahren zu seiner Herstellung"

Die Erfindung bezieht sich auf einen Verbundwerkstoff für
elektrische Kontakte, vorzugsweise für Schalt-, Steck- oder
Schleifkontakte, der auf einer Unterlage, wie einer Kontaktfeder
oder einem Kontaktstift, aus einem Unedelmetall oder einer
Unedelmetall-Legierung, eine Kontaktschicht aus Titan-Nitrid
aufweist.

Ein Verbundwerkstoff der vorgenannten Art ist aus der FR
- OS 25 18 325 bekannt. Die Kontaktschicht dieses Verbundwerkstoffs besitzt eine gute mechanische Verschleißfestigkeit,
jedoch ist der Kontaktwiderstand der Titan-Nitrid-Schicht
relativ hoch.

Der Erfindung liegt die Aufgabe zugrunde, den bekannten Verbundwerkstoff hinsichtlich seines Kontaktwiderstandes zu
verbessern, d. h. diesen zu erniedrigen, unter Beibehaltung
einer möglichst hohen mechanischen Verschleißfestigkeit.

Gelöst wird diese Aufgabe für einen Verbundwerkstoff der
eingangs charakterisierten Art erfindungsgemäß dadurch, daß
die der Unterlage abgekehrte Oberfläche der Titan-Nitrid-
Schicht eine Mischschicht aus Titan-Nitrid und wenigstens
einem Edelmetall aus der Gruppe Gold, Silber, Palladium,
Platin, Ruthenium, Rhodium und Iridium aufweist, deren Dicke etwa 1/10 bis 3/10 der Schichtdicke der Titan-Nitrid-Schicht beträgt und deren Edelmetallgehalt zwischen 40 und 95 % beträgt.

Bewährt haben sich Mischschichten, in denen deren Bestandteile, nämlich Titan-Nitrid und Edelmetall, gleichmäßig verteilt vorliegen. Besonders gute Ergebnisse hinsichtlich der Verminderung des Kontaktwiderstandes unter Beibehaltung einer guten mechanischen Verschleißfestigkeit zeigen solche erfindungsgemäßen Verbundwerkstoffe, bei denen in der Mischschicht ein Konzentrationsgefälle des Edelmetalls vorliegt, wobei dessen Konzentration von der kontaktgebenden Oberfläche der Mischschicht nach innen zu abnimmt.

Bei erfindungsgemäßen Verbundwerkstoffen liegt die Schichtdicke der Titan-Nitrid-Schicht vorzugsweise im Bereich von 0,5 bis 1,5 µm und die Dicke der Mischschicht im Bereich von 0,05 bis 0,45 µm.

Als Werkstoff für die Unterlage haben sich in der Kontakttechnologie übliche Werkstoffe bewährt, insbesondere Kupfer, Kupfer-Legierungen, Nickel-Legierungen, Stahl, Molybdän oder Wolfram.

Die Herstellung von erfindungsgemäßen Verbundwerkstoffen für elektrische Kontakte erfolgt in einem gegebenenfalls Argon enthaltenden Behälter, in dem ein Druck von weniger als $5 \times 10^{-2}$ mbar aufrechterhalten wird. Auf der Unterlage wird die Kontaktschicht aus Titan-Nitrid niedergeschlagen, wobei während des Beschichtungsverfahrens zur Reaktion mit verdampftem oder zerstäubtem Titan Stickstoff in den Behälter eingeleitet und das als Reaktionsprodukt gebildete Titan-Nitrid auf der erwärmten Unterlage niedergeschlagen wird. Nach Erreichen einer vorgegebenen Kontaktschichtdicke wird zur Bildung einer Mischschicht ohne Unterbrechung der Titan-Nitrid- Bildung zusätzlich Edelmetall verdampft oder zerstäubt und dieses zusammen mit dem gebildeten Titan-Nitrid auf der

- 3 -